Europäisches Patentamt

European Patent Office

Office européen des brevets

(19)

(11) Veröffentlichungsnummer: **0 207 487**

**A2**

(12) # EUROPÄISCHE PATENTANMELDUNG

(21) Anmeldenummer: 86108899.5

(22) Anmeldetag: 30.06.86

(51) Int. Cl.⁴: **H03K 19/173**

(30) Priorität: 03.07.85 DE 3523839

(43) Veröffentlichungstag der Anmeldung:
07.01.87 Patentblatt 87/02

(84) Benannte Vertragsstaaten:
AT CH DE FR GB LI SE

(71) Anmelder: **Siemens Aktiengesellschaft Berlin und München**
**Wittelsbacherplatz 2**
**D-8000 München 2(DE)**

(72) Erfinder: **Kick, Horst**
**Am Schäferloch 26**
**D-7519 Walzbachtal 2(DE)**

(54) **Programmierbare Schaltung zur logischen Verknüpfung von binären Signalen.**

(57) Zur logischen Verknüpfung von binären Signalen ist ein Multiplexer (MUX) vorhanden, dessen Steuereingängen (A, B, C) die zu verknüpfenden Signale und dessen Dateneingängen (E1, E2 ... E8) ein die jeweilige Verknüpfungsfunktion kennzeichnender Verknüpfungscode zugeführt sind.

Die Erfindung wird angewandt bei der Auswertung von Fernsehbildern.

FIG 1

EP 0 207 487 A2

## Schaltungsanordnung zur logischen Verknüpfung von binären Signalen

Es ist bekannt, zur logischen Verknüpfung von binären Signalen für jede Verknüpfungsfunktion eine spezielle Schaltung vorzusehen. Oft ist es nicht erforderlich, daß die von einer Anordnung auszuführenden verschiedenen logischen Verknüpfungsfunktionen gleichzeitig parallel ausgeübt werden, sondern es wird jeweils nur eine Funktion in Abhängigkeit der gewählten Betriebsart der Anordnung ausgeführt. In solchen Fällen können zur logischen Verknüpfung programmierbare Rechner verwendet werden, die aber wegen ihrer seriellen Arbeitsweise den Nachteil einer niedrigen Arbeitsgeschwindigkeit haben.

Der vorliegenden Erfindung liegt die Aufgabe zugrunde, eine Schaltungsanordnung zum logischen Verknüpfen von binären Signalen zu - schaffen, die programmierbar wahlweise verschiedene logische Funktionen mit hoher Geschwindigkeit ausführt.

Erfindungsgemäß wird diese Aufgabe mit den im kennzeichnenden Teil des Anspruchs 1 angegebenen Maßnahmen gelöst. Die neue Anordnung enthält somit als Hauptbestandteil lediglich einen Multiplexer, ein Bauelement, das, auch wenn seine maximale Taktfrequenz, entsprechend der Bildpunktfrequenz bei der Auswertung von Fernsehbildern, preisgünstig im Handel erhältlich ist.

Anhand der Zeichnungen werden im folgenden ein Ausführungsbeispiel der Erfindung sowie Vorteile und Weiterbildungen näher beschrieben und erläutert.

In Figur 1 ist das Prinzipschaltbild des Ausführungsbeispiels dargestellt.

Figur 2 veranschaulicht die Funktion des Ausführungsbeispiels.

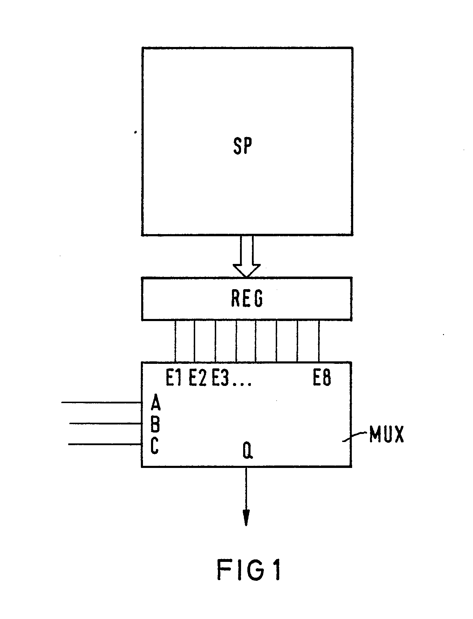

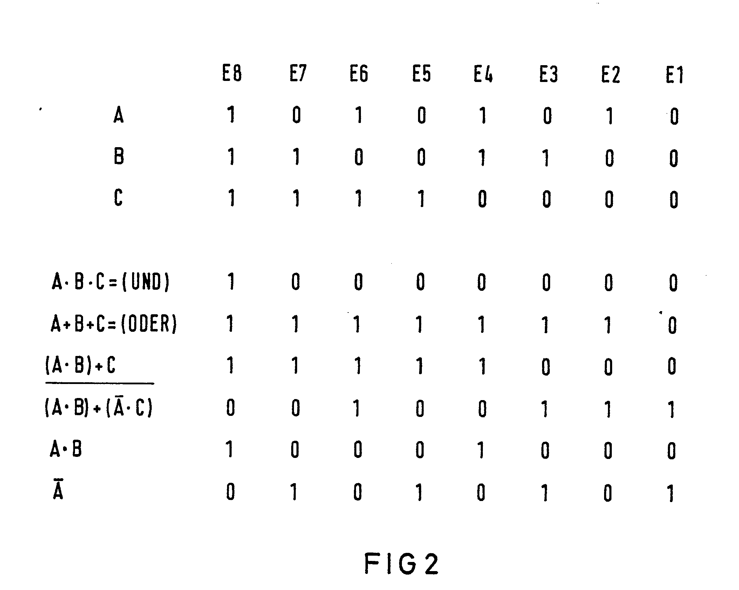

In Figur 1 ist mit MUX ein Multiplexer mit Signaleingängen E1, E2, E3 ... E8 und mit Steuereingängen A, B, C bezeichnet. Wie bei Multiplexern üblich, wird bei jeder Signalkombination an den Steuereingängen A, B, C das Signal von einem durch diese Signalkombination bestimmten Eingang E1, E2, ... zum Ausgang Q durchgeschaltet. In den ersten drei Zeilen der Figur 2 ist dies veranschaulicht. Beispielsweise wird bei der Signalkombination "111" das Signal am Eingang E8, bei der Kombination "101" das Signal am Eingang E6 und bei der Kombination "000" das Signal vom Eingang E1 durchgeschaltet. Den Steuereingängen A, B, C werden die zu verknüpfenden binären Signale und den Eingängen E1, E2, E3 ... ein die Verknüpfungsfunktion bestimmender Verknüpfungscode zugeführt. Dieser Verknüpfungscode ist in einem Register REG für die Zeit gespeichert, während der die Verknüpfungsfunktion bestehen soll. Die verschiedenen Verknüpfungscodes sind in einem Speicher SP enthalten, aus dem sie wahlweise abgerufen werden können.

Sollen die Signale an den Eingängen A, B, C nach einer UND-Funktion A.B.C verknüpft werden, wird den Eingängen E1 ... E8 der Code 1000 0000 zugeführt, wie in der vierten Zeile der Figur 2 dargestellt ist. Es ist ersichtlich, daß nur dann eine "1" zum Ausgang durchgeschaltet wird, wenn an allen drei Eingängen A, B, C eine "1" anliegt. In der nächsten Zeile ist der Verknüpfungscode für die ODER-Funktion A + B + C angegeben. Es erscheint nur dann am Ausgang eine "0", wenn an allen drei Eingängen A, B, C "0"-Signal liegt. Für die Invertierung des dem Eingang A zugeführten Signals ist der Code 0101 0101 (Zeile 6 der Figur 2), und für die UND-Verknüpfung von den Eingängen A und B zugeführten Signale, unabhängig vom Signal am Eingang C, ist der Code 1000 1000 erforderlich (Zeile 7). Auch komplexe logische Verknüpfungen (A.B) + C oder (A.B) + - ( $\overline{A}$.C) sind realisierbar, wie in den beiden letzten Zeilen gezeigt. Insgesamt sind 256, also alle bei drei Eingangsvariablen möglichen Verknüpfungsfunktionen realisierbar. Sollen nur zwei Eingangssignale verknüpft werden, genügt ein Multiplexer mit vier Dateneingängen, ist die Zahl der Eingangsvariablen dagegen "4" oder "n", sind 16 bzw. $2^n$ Dateneingänge erforderlich. Vor allem bei einer größeren Anzahl von Eingangsvariablen wird man nicht mit einem einzigen Multiplexer-Baustein auskommen; man wird dann eine Multiplexer-Kombination einsetzen. In jedem Falle erfolgt die Verknüpfung sehr rasch. Z.B. können ohne weiteres für die Verarbeitung von Fernsehbildern binäre Bildsignale mit der Bildpunktfrequenz von 12 MHz verknüpft werden.

## Ansprüche

1. Schaltungsanordnung zur logischen Verknüpfung von binären Signalen, **dadurch gekennzeichnet,** daß die zu verknüpfenden Signale den Steuereingängen (A, B, C) eines Multiplexers - (MUX) zugeführt sind, dessen Dateneingänge ein die Verknüpfungsfunktion bewirkender Verknüpfungscode zugeführt ist.

2. Schaltungsanordnung nach Anspruch 1, **dadurch gekennzeichnet,** daß die Verknüpfungscodes in einem Speicher (SP) enthalten sind, aus dem sie je nach gewünschter Verknüpfungsfunktion abgerufen und an die Dateneingänge (E1, E2, E3) des Multiplexers (MUX) angelegt werden.

FIG 1

| | E8 | E7 | E6 | E5 | E4 | E3 | E2 | E1 |
|---|---|---|---|---|---|---|---|---|
| A | 1 | 0 | 1 | 0 | 1 | 0 | 1 | 0 |
| B | 1 | 1 | 0 | 0 | 1 | 1 | 0 | 0 |
| C | 1 | 1 | 1 | 1 | 0 | 0 | 0 | 0 |
| $A \cdot B \cdot C = (UND)$ | 1 | 0 | 0 | 0 | 0 | 0 | 0 | 0 |
| $A + B + C = (ODER)$ | 1 | 1 | 1 | 1 | 1 | 1 | 1 | 0 |
| $\overline{(A \cdot B) + C}$ | 1 | 1 | 1 | 1 | 1 | 0 | 0 | 0 |
| $(A \cdot B) + (\bar{A} \cdot C)$ | 0 | 0 | 1 | 0 | 0 | 1 | 1 | 1 |
| $A \cdot B$ | 1 | 0 | 0 | 0 | 1 | 0 | 0 | 0 |
| $\bar{A}$ | 0 | 1 | 0 | 1 | 0 | 1 | 0 | 1 |

FIG 2